# EUROPÄISCHE PATENTSCHRIFT

(11) **EP 1 110 917 B1**
(45) Veröffentlichungstag und Bekanntmachung des Hinweises auf die Patenterteilung: **08.10.2003**
(21) Anmeldenummer: 00127401.8
(22) Anmeldetag: 14.12.2000
(51) Int. Cl.: C03B 19/09, C30B 31/10, C03C 3/06, C03C 11/00, C30B 25/08

(54) **Verfahren für die Herstellung von opakem Quarzglas und nach dem Verfahren hergestelltes opakes Bauteil**
Method of producing opaque silica glass and opaque elements produced by the process
Procédé de fabrication de verre de silice opaque et des éléments opaques produits par le procédé

(30) Priorität: 22.12.1999 DE 19962452
(43) Veröffentlichungstag der Anmeldung: 27.06.2001
(73) Patentinhaber: Heraeus Quarzglas GmbH & Co. KG, 63450 Hanau (DE)
(72) Erfinder: Werdecker, Waltraud, 63456 Hanau (DE); Leist, Johann, 63674 Altenstadt (DE); Fabian, Heinz, 63762 Grossostheim (DE); Uebbing, Bruno, Dr., 63755 Alzenau (DE); Rosin, Erich, 63486 Bruchköbel (DE); Göbel, Rolf, 63571 Gelnhausen (DE)

(56) Entgegenhaltungen:
- EP-A- 0 715 342
- EP-A- 0 728 709
- EP-A- 0 816 297
- EP-A- 0 909 743
- DE-A- 4 440 104
- DE-A- 19 523 954
- DE-C- 4 214 563
- GB-A- 330 943
- GB-A- 2 018 743
- US-A- 5 862 302
- PATENT ABSTRACTS OF JAPAN vol. 1998, no. 3, 27. Februar 1998 (1998-02-27) & JP 09 301726 A (TOSHIBA CERAMICS CO LTD), 25. November 1997 (1997-11-25)
- PATENT ABSTRACTS OF JAPAN vol. 1999, no. 13, 30. November 1999 (1999-11-30) & JP 11 236234 A (TOSOH CORP ET AL), 31. August 1999 (1999-08-31)

## Beschreibung

Die Erfindung betrifft ein Verfahren für die Herstellung von opakem Quarzglas, durch Bereitstellen einer Mischung umfassend SiO₂-Partikel und ein bei der Schmelztemperatur dieser Partikel verdampfendes Zusatzmittel, Bilden eines Formlings aus der Mischung, und Schmelzen des Formlings durch Erhitzen bei der Schmelztemperatur unter Bildung einer im Formling fortschreitenden Schmelzfront. Weiterhin betrifft die Erfindung ein Bauteil aus opakem, porenhaltigem Quarzglas.

Weiterhin betrifft die Erfindung ein Bauteil aus opakem, porenhaltigem Quarzglas, das eine von einer Innenwandung umschlossene Öffnung aufweist.

Opakes Quarzglas wird zur Herstellung von Formkörpern für wärmetechnische Anwendungen eingesetzt, bei denen es auf gute Wärmeisolierung bei gleichzeitig hoher Temperaturstabilität ankommt. Dabei werden zunehmend höhere Anforderungen an die Reinheit derartiger Quarzglas-Formkörper gestellt. Als Beispiel seien Anwendungen in der Halbleiterindustrie genannt, bei denen opakes Quarzglas für Rohre, Glocken und für Flansche von Diffusionsrohren eingesetzt wird. Bei Quarzglas geringer Reinheit tritt durch die darin enthaltenen Verunreinigungen Opazität von allein ein. Demgegenüber wird bei reinen Quarzglas-Ausgangsstoffen die Opazität der Formkörper durch Poren im Quarzglas erreicht. Opazität bedeutet in diesem Zusammenhang niedrige Transmission (kleiner ein Prozent) sowohl im Sichtbaren (etwa zwischen 350 nm und 800 nm) als auch im IR-Bereich ( etwa von 750 nm bis 4800 nm). Die Herstellung von opakem Quarzglas aus reinen Ausgangsstoffen ist Gegenstand dieser Erfindung.

Ein gattungsgemäßes Verfahren zur Herstellung von opakem Quarzglas aus reinen Ausgangsstoffen ist in der EP-A1 816 297 beschrieben. Darin wird vorgeschlagen, hochreines amorphes SiO₂-Partikel aus gereinigter, natürlicher, kristalliner Quarzkörnung oder aus synthetisch hergestelltem, amorphem SiO₂ mit reinem, pulverförmigem Siliciumnitrid (Si₃N₄) zu mischen, die Pulvermischung in einer mit Graphitfilz ausgekleideten Graphitform zu füllen und in einem elektrisch beheizten Ofen bei einer Temperatur im Bereich zwischen 1400 °C und 1900 °C entweder unter Vakuum oder in einer Inertgasatmosphäre zu erhitzen.

Die Heiztemperatur und -dauer wird so gewählt, daß das SiO₂-Partikel unter Bildung eines Formkörpers vollständig geschmolzen wird. Die genannte Temperaturuntergrenze von 1400 °C wird dabei durch die Schmelztemperatur des eingesetzten SiO₂-Partikels vorgegeben, während ein Schmelzen bei Temperaturen oberhalb von 1900 °C zu sehr großen Blasen führt, die die mechanische Festigkeit des Quarzglases beeinträchtigen. Beim Schmelzen wandert die Front des sich erweichenden und schmelzenden Quarzglases als "Schmelzfront" von der Graphitform aus radial nach innen. Dabei werden durch thermische Zersetzung des Si₃N₄-Pulvers gasförmige Komponenten, wie Stickstoff, freigesetzt. Die gasförmigen Komponenten führen zu Blasenbildung im erweichten Quarzglas und erzeugen so die gewünschte Opazität des Formkörpers.

Ein nach dem bekannten Verfahren hergestellter Formkörper besteht aus opakem Quarzglas, das sich durch eine spezifische Dichte im Bereich zwischen 1,7 und 2,1 g/cm³, einen Gehalt an geschlossenen Blasen mit einem Durchmesser zwischen 10 und 100 µm im Bereich von 3 x 10⁵ und 5 x 10⁶ Blasen/cm³ und durch eine Gesamtblasenfläche von 10 bis 40 cm²/cm³ bei homogener Blasenverteilung auszeichnet.

Entglasungen des opaken Quarzglases führen zu Sprödigkeit und verminderter Temperaturwechselbeständigkeit. Um dies zu vermeiden, wird bei dem bekannten Verfahren vorgeschlagen, hochreine Ausgangsstoffe einzusetzen. Kontaminationen des Formlings treten jedoch auch während des Herstellungsprozesses auf. Als Kontaminationsquelle kommen bei dem bekannten Verfahren die Schmelzform, der Graphitfilz und die Schmelzatmosphäre in Frage. Auch nicht oder nicht vollständig umgesetzte Zusatzmittel-Reste können die Qualität des Formkörpers beeinträchtigen.

Der Erfindung liegt die Aufgabe zugrunde, ein Verfahren für die Herstellung von reinem, opakem Quarzglas anzugeben, bei dem die Gefahr von Kontaminationen beim Herstellungsprozess verringert ist, und ein Bauteil aus reinem, opakem Quarzglas bereitzustellen, das sich durch hohe Temperaturwechselbeständigkeit und Festigkeit und chemische Beständigkeit auszeichnet.

Hinsichtlich des Verfahrens wird diese Aufgabe ausgehend von dem eingangs genannten Verfahren erfindungsgemäß dadurch gelöst, daß ein Formling gebildet wird, der eine Innenbohrung aufweist, und daß das Erhitzen des Formlings derart erfolgt, daß die Schmelzfront von der Innenbohrung nach außen fortschreitet, wobei Verunreinigungen und freiwerdende Gase in Richtung noch poröser Bereiche des Formlings getrieben werden.

Der Formling wird als lose Schüttung oder als mechanisch, chemisch oder thermisch vorver - dichteter, poröser Grünkörper aus einer Mischung aus amorphen oder kristallinen SiO₂-Partikeln und dem Zusatzmittel gebildet. Das Zusatzmittel liegt im allgemeinen als Pulver oder als Flüssigkeit vor.

Bei der Schmelzfront handelt es sich um einen unscharfen Grenzbereich zwischen geschmolzenem und angeschmolzenem Material. Im angeschmolzenen Material liegen offene Poren und Kanäle vor, während das geschmolzene Material geschlossene Poren aufweist.

Unter der "Schmelztemperatur" wird diejenige höchste Temperatur verstanden, die beim Schmelzen an der Wandung der Innenbohrung des Formlings gemessen wird.

Der Formling wird von der Innenbohrung aus erhitzt, so daß die Schmelzfront von der Innenbohrung aus durch die Wandung des Formlings nach außen wandert. Form und Lage der Innenbohrung im Formling sind für die Erfindung nicht entscheidend; im einfachsten Fall ist die Innenbohrung als zentrale Durchgangsbohrung ausgebildet.

Erfindungsgemäß wandert die Schmelzfront von der Innenwandung der Innenbohrung durch den Formling nach außen. Sublimierbare Verunreinigungen werden dabei in die Gasphase überführt. In erster Linie sind hier sublimierbare Verunreinigungen relevant, die bei der Schmelztemperatur aus dem SiO₂-Partikel oder aus dem Zusatzmittel entweichen oder die von einer Heizquelle oder der Heizatmosphäre stammen. Die Verunreinigungen werden vor der Schmelzfront nach außen, in Richtung noch poröser Bereiche des Formlings getrieben.

Das bei der Schmelztemperatur verdampfende Zusatzmittel setzt bei der Schmelztemperatur Gase frei. Die Gase entstehen durch Umsetzung (Verdampfung oder Zersetzung) des Zusatzmittels und führen bestimmungsgemäß zur Blasenbildung im Bereich des erweichten Quarzglases. Aufgrund der sich nach außen bewegenden Schmelzfront gelangen die Gase in Randbereiche des Formlings wo sie entweichen oder abgesaugt werden können. Zusatzmittel-Reste können die Entglasungsbeständigkeit des opaken Quarzglases beeinträchtigen; da die zentralen Bereiche um die Innenbohrung der Schmelztemperatur am längsten ausgesetzt sind, ist dort die Umsetzung des Zusatzmittels jedoch vollständig oder am weitesten fortgeschritten. Da das dabei entstehende Gas nach außen getrieben wird, ist auch die Porosität des geschmolzenen Formkörpers in diesem Bereich besonders gering und nimmt nach außen hin zu. Darin unterscheidet sich das erfindungsgemäße Verfahren von dem eingangs beschriebenen bekannten Verfahren. Denn bei diesem wandert die Schmelzfront von außen radial nach innen, so daß sich Verunreinigungen ― die beispielsweise aus der Graphit-Schmelzform oder aus dem Graphitfilz stammen ― bevorzugt im zentralen Bereich des Formlings anreichern, wo sie im allgemeinen besonders störend wirken und kaum noch zu entfernen sind.

Infolge der oben näher erläuterten Wirkung der radial von innen nach außen wandernden Schmelzfront wird beim erfindungsgemäßen Verfahren die Gefahr einer Kontamination des opaken Quarzglases durch Verunreinigungen, die aus dem Herstellungsprozess resultieren, vermindert. Die Heizquelle in der Innenbohrung des Formlings ist von arteigenem Material (SiO₂-Partikel) umgeben, das gleichzeitig als thermische Isolierung der Heizquelle nach außen dient. Kontaminationen aus einem artfremden Isolationsmaterial werden so vermieden.

Es ist nicht erforderlich, und im Hinblick auf die Erhaltung einer möglichst hohen Reinheit des geschmolzenen Formkörpers im allgemeinen auch nicht erwünscht, daß die Schmelzfront über die gesamte Wandstärke des Formlings fortschreitet. Eine Restschicht ungeschmolzener SiO₂-Partikel erleichtert die Entnahme des geschmolzenen Formkörpers aus einer Form, trägt während des Schmelzens zum Ableiten von Gasen bei und verhindert das Eindiffundieren von Verunreinigungen von außen, wie etwa aus einem artfremden Formmaterial.

Vorteilhafterweise wird der Formling bereichsweise (zonenweise) entlang einer Längsachse der Innenbohrung erhitzt. Diese Verfahrensvariante erlaubt die Einstellung einer besonders hohen Schmelztemperatur. Eine hohe Schmelztemperatur (beispielsweise oberhalb von 1900 °C) trägt zu einer vollständigen Umsetzung des eingesetzten Zusatzmittels bei. Zusatzmittel-Reste im geschmolzenen Formkörper werden so vermieden. Bei dieser Verfahrensvariante können auch solche Zusatzmittel, wie Si₃N₄, die ansonsten bei hohen Temperaturen zu einem Wachstum unerwünscht großer Blasen auf Kosten kleinerer Blasen neigen, problemlos eingesetzt werden. Dies wird dadurch erreicht, daß der Formling sukzessive und zonenweise entlang der Innenbohrung erhitzt wird. Dabei wird eine Heizquelle kontinuierlich oder in kleinen Schritten relativ zur Innenwandung entlang der Innenbohrung bewegt (in kinematischer Äquivalenz können Formling und/oder Heizquelle bewegt werden). Die Heizquelle erzeugt im Formling einen erhitzten und erweichten Bereich geringer Viskosität, der im folgenden als Erweichungszone bezeichnet wird. Die Erweichungszone bewegt sich mit der Heizquelle entlang der Innenbohrung. Durch diese ständige Verlagerung der Heizzone wird jeder Bereich des Formlings nur kurzzeitig der Schmelztemperatur ausgesetzt, so daß sich auch die Erweichungszone nur entsprechend kurzzeitig ausbildet und dieser Bereich sogleich wieder abkühlt. In der Erweichungszone entstehende Blasen werden beim Abkühlen sogleich wieder "eingefroren". Ein Blasenwachstum, das eine geringe Viskosität über eine längere Zeitspanne voraussetzt, wird so verhindert. Das Schmelzen des Formlings kann ein mehrmaliges Hin- und Herbewegen der Heizquelle entlang der Längsachse der Innenbohrung erfordern; vorzugsweise erfolgt das Schmelzen aber in nur einem Durchgang.

Dabei hat es sich als günstig erwiesen, den Formling um die Längsachse der Innenbohrung zu rotieren. Die Rotation gewährleistet eine gleichmäßige Erhitzung des Formlings, Temperaturspitzen werden vermieden.

Besonders bewährt hat sich eine Verfahrensweise, bei der das Erhitzen des Formlings mittels eines Lichtbogens erfolgt, wobei die Schmelztemperatur auf einen Wert oberhalb von 1900 °C eingestellt wird. Der Lichtbogen brennt dabei in der Innenbohrung der Formlings. Beim Erhitzen in einem Lichtbogen wird die Mischung aus SiO₂-Partikel und Zusatzmittel besonders hohen Temperaturen oberhalb von 1900 °C ausgesetzt. Infolge der hohen Temperaturen laufen Diffusions- und andere Stoffaustauschvorgänge beschleunigt ab. Verunreinigungen, insbesondere in Gasform, lassen sich dadurch wirkungsvoll beseitigen, indem sie expandieren und vor der Schmelzfront nach außen entweichen. Das Zusatzmittel wird möglichst vollständig umgesetzt, so daß Zusatzmittel-Reste vermieden werden. Um die Gefahr einer Verunreinigung des Formlings weiter zu verringern, bestehen die für die Erzeugung des Lichtbogens erforderlichen Elektroden aus hochreinen Werkstoffen. Es gibt keinen Kontakt der Elektroden mit der Wandung der Innenbohrung. Bei besonders hohen Reinheitsanforderungen wird die Innenbohrung mit einem Gas gespült oder die Heizatmosphäre wird abgesaugt.

Als Ausgangsmaterial (SiO₂-Partikel) für das erfindungsgemäße Verfahren wird, da besonders hohe Anforderungen an die Reinheit des opaken Quarzglases gestellt werden, als Ausgangsmaterial ein in einem Granulierverfahren hergestelltes Granulat aus synthetisch erzeugtem SiO₂ eingesetzt. Das poröse Granulat wird vor dem Einsatz vorverdichtet. Das Verdichten erfolgt durch vollständiges oder teilweises Sintern des porösen Granulats. Die höhere Dichte des Granulats vermindert eine Anlagerung oder Absorption von Verunreinigungen.

Bevorzugt wird ein Zusatzmittel eingesetzt, das eine oder vorzugsweise mehrere der Komponenten Siliciumcarbid (SiC), Aluminiumnitrid (AIN), Siliciumnitrid (Si₃N₄), Zirkoniumoxid (ZrO₂) Zirkonsilikat (ZrSiO₄), Kohlenstoff (C) oder eine kohlenstoffhaltige Substanz enthält.

Ergänzend, jedoch vorzugsweise alternativ dazu wird ein Zusatzmittel eingesetzt, das nanoskaliges SiO₂-Pulver enthält. Bei derartigem nanoskaligem SiO₂-Pulver handelt es sich um Pulver, wie es aufgrund der bekannten Herstellungsverfahren für synthetisches Quarzglas - wie etwa bei der Flammenhydrolyse oder Oxidation von anorganischer Siliziumverbindungen oder bei Sol-Gel-Verfahren organischer Siliziumverbindungen - anfällt. Derartige nanoskalige SiO₂-Pulver zeichnen sich durch eine besonders große Oberfläche aus, die mehrere hundert m²/g (BET-Oberfläche) betragen kann. Es hat sich überraschend gezeigt, daß derartiges SiO₂-Pulver als Zusatzmittel im Sinne dieser Erfindung geeignet ist, da es beim Erhitzen Gase freisetzt, die zur gewünschten Opazität führen. Der besondere Vorteil beim Einsatz von nanoskaligem SiO₂-Pulver als Zusatzmittel besteht darin, daß es sich um ein - dem opaken Quarzglas - arteigenes Material handelt, so daß ein Eintrag von Fremdstoffen vermieden wird.

Hinsichtlich des Bauteils aus opakem, porenhaltigem Quarzglas wird die oben angegebene Aufgabe erfindungsgemäß dadurch gelöst, daß es eine von einer Innenwandung umschlossene Öffnung aufweist, und daß die Innenwandung mit einer inneren SiO₂-Oberflächenschicht, die im Bereich einer Schichtdicke von 30 µm bis 500 µm eine Dichte von mindestens 2,15 g/cm³ aufweist, versehen ist.

Bei dem Bauteil handelt es sich beispielsweise um einen Hohlzylinder, einen Behälter, einen Flansch, einen Tiegel oder um eine Glocke aus Quarzglas. Das Bauteil kann rotationssymmetrisch ausgebildet sein. Die der Öffnung des Bauteils zugewandte, freie Oberfläche aus Quarzglas wird hier als "SiO₂-Oberflächenschicht" oder als "Oberflächenschicht" bezeichnet.

Die Oberflächenschicht ist porenfrei oder derart porenarm, daß sie eine Dichte von mindestens 2,15 g/cm³ aufweist. Diese Dichte kommt derjenigen von transparentem Quarzglas nahe. Dementsprechend entsprechen die mechanischen und chemischen Eigenschaften der Oberflächenschicht denjenigen von dichtem, transparentem Quarzglas. Unter anderem zeichnet sich die Oberflächenschicht und damit das erfindungsgemäße opake Bauteil durch hohe mechanische Festigkeit und Härte, geringe Abrasion und chemische Beständigkeit aus. Die SiO₂-Oberflächenschicht besteht aus dem gleichen Material wie der Rest des Bauteils. Dies wirkt sich auf die Temperaturwechselbeständigkeit des Bauteils vorteilhaft aus.

Die Oberflächenschicht des opaken Quarzglas-Bauteils wird dadurch erzeugt, daß ein Formling als lose Schüttung oder als mechanisch, chemisch oder thermisch vorverdichteter, poröser Grünkörper aus amorphen oder kristallinen SiO₂-Partikeln und einem bei einer Schmelztemperatur volatilen Zusatzmittel gebildet wird. Der Formling weist eine Innenbohrung auf und wird zum Schmelzen derart erhitzt, daß eine Schmelzfront von der Innenbohrung aus nach außen fortschreitet. Im übrigen wird auf die obigen Erläuterungen zum erfindungsgemäßen Verfahren verwiesen. Bei diesem Verfahren wird ein geschmolzener Formkörper mit einer Innenbohrung erhalten, der im Bereich um die Innenbohrung am stärksten erhitzt worden ist. Dieser Bereich bildet nach dem Schmelzen die als "Oberflächenschicht" bezeichnete dichte Oberfläche, während die äußeren Bereiche porös sind. Durch Bearbeitung mittels bekannter Verfahren (Heißverformen, Schneiden, Sägen, Bohren usw.) kann aus dem Formkörper das gewünschte Bauteil aus opakem Quarzglas erzeugt werden.

Das erfindungsgemäße Bauteil ist insbesondere für die Herstellung von Behältern, Muffeln, Hitzeschilden oder Rohren geeignet, bei denen es auf eine temperaturstabile, chemisch resistente oder dichte, arteigene Innenoberfläche ankommt. Diese Funktionen übernimmt beim erfindungsgemäßen Bauteil die Oberflächenschicht, während die opake Wandung zum Wärmehaltevermögen beiträgt.

Die Dicke der Oberflächenschicht ist auf etwa 500 µm begrenzt, damit die Dämmwirkung hinsichtlich Wärme und sichtbarer Strahlung erhalten bleibt. Die angegebene Mindestdicke dieser Oberflächenschicht von 30 µm ist erforderlich, um die genannten mechanischen und chemischen Eigenschaften dieser Oberfläche und damit des Bauteils zu gewährleisten.

Als besonders vorteilhaft hat sich eine Schichtdicke der Oberflächenschicht im Bereich von 50 µm bis 200 µm erwiesen.

Nachfolgend wird die Erfindung anhand von Ausführungsbeispielen und einer Zeichnung näher erläutert. In der Zeichnung zeigen in schematische Darstellung im einzelnen:
- **Figur 1**: den Verfahrensschritt des Schmelzens am Beispiel eines Hohlzylinders in einem Ausschnitt, und
- **Figur 2**: einen radialen Querschnitt durch ein rotationssymmetrisches Bauteil gemäß der Erfindung.

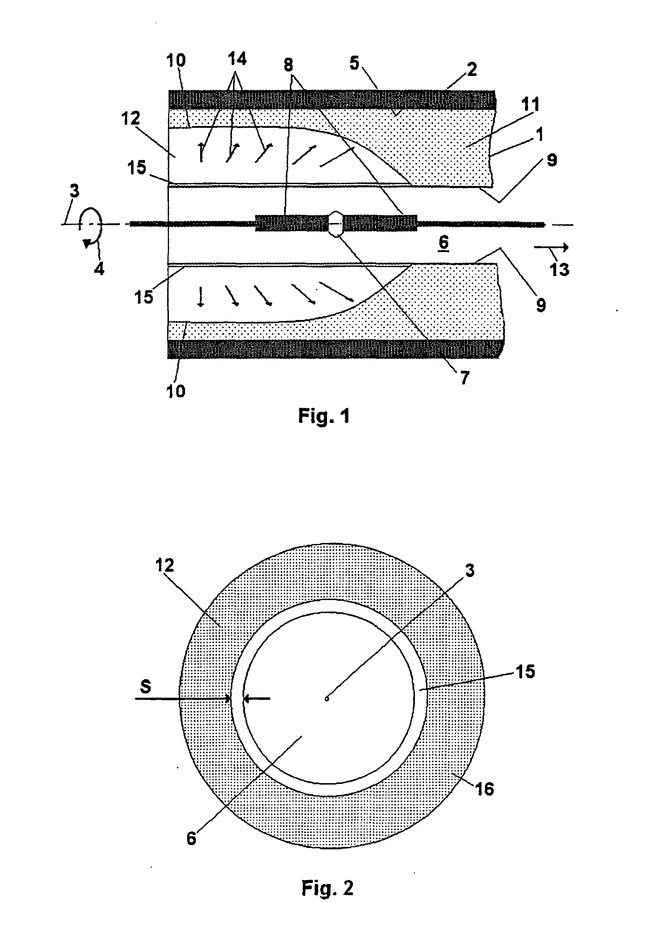

In **Figur 1** ist schematisch der für das erfindungsgemäße Verfahren wesentliche Verfahrensschritt des Schmelzens eines Hohlzylinders 1 dargestellt. Im folgenden wird zunächst die Herstellung des Hohlzylinders 1 anhand zweier Ausführungsvarianten erläutert:

### Ausführungsvariante 1 für die Herstellung eines Hohlzylinders:

Kristalline Körnung aus natürlichem Quarz mit einer Korngröße von 90 bis 315 µm wird mittels Heißchlorierung gereinigt. Die gereinigte kristalline Quarzkörnung wird mittels eines Mischers mit reinem Si₃N₄-Pulver, das einen mittleren Korndurchmesser von ca. 0,5 µm aufweist, homogen vermischt, wobei 0,01 Gew.-% Si₃N₄-Pulver, bezogen auf das Gewicht der Quarzkörnung, eingewogen werden. Das Gemisch aus gereinigter natürlicher Quarzkörnung und Si₃N₄-Pulver wird anschließend in eine rohrförmige Metallform 2 eingefüllt, die um ihre Längsachse 3 rotiert. Die Rotationsrichtung ist in Figur 1 mit dem Richtungspfeil 4 gekennzeichnet. Unter der Wirkung der Zentrifugalkraft und Zuhilfenahme einer Schablone wird aus der Schüttung an der Innenwandung 5 der Metallform 2 ein rotationssymmetrischer Hohlzylinder 1 geformt. Der Hohlzylinder 1 hat in der Schüttung eine Schichtdicke von ca. 100 mm und eine Innenbohrung 5 in Form einer Durchgangsbohrung 6 mit einem Innendurchmesser von etwa 110 mm. Durch die Zentrifugalkraft wird die Schüttung vor Durchführung der nachfolgenden Verfahrensschritte leicht verfestigt.

### Ausführungsvariante 2 für die Herstellung eines Hohlzylinders:

Mittels eines üblichen Granulierverfahrens wird ein Granulat aus amorphen, nanoskaligen SiO₂-Partikeln, die durch Flammenhydrolyse von SiCl₄ erzeugt sind, hergestellt. Das SiO₂-Granulat wird anschließend bei eine Temperatur von ca. 1300 °C unter Bildung hochreiner, amorpher SiO₂-Körnung verdichtet. Die SiO₂-Körnung, deren mittlerer Korndurchmesser bei ca. 250 µm liegt, wird mittels eines Mischers mit hochreinem Si₃N₄-Pulver und hochreinem AIN-Pulver homogen vermischt. Der Gewichtsanteil des Si₃N₄-Pulvers, bezogen auf das Gewicht der Quarzkörnung beträgt dabei 0,008 Gew.-% und der des AIN-Pulvers 15 Gew.-ppm (die Angabe bezieht sich auf Al). Das Pulvergemisch aus SiO₂-Körnung und den Zusatzstoffen wird anschließend wie in Ausführungsvariante 1 beschrieben in einer Metallform 2 zu einem hohlzylindrischen und um die Längsachse 3 rotationssymmetrischen Hohlzylinder 1 geformt, der in diesem Fall in der Schüttung eine Schichtdicke von ca. 27 mm und ein Innenbohrung 5 mit einem Innendurchmesser von etwa 110 mm aufweist.

### Ausführungsbeispiel für das Schmelzen eines Formlings:

Die folgenden Erläuterungen beziehen sich sowohl auf das Schmelzen des Hohlzylinders 1 nach Ausführungsvariante 1 als auch nach Ausführungsvariante 2.

Der mechanisch vorverdichtete Hohlzylinder 1 wird mittels eines Lichtbogens 7 von der Innenbohrüng 6 des Hohlzylinders 1 aus zonenweise geschmolzen. Hierzu wird von einem Ende des Hohlzylinders 1 beginnend ein Elektrodenpaar 8 in die Innenbohrung 6 eingeführt und zum gegenüberliegenden Ende des Hohlzylinders 1 hin und entlang der Innenwandung 9 kontinuierlich bewegt. Die Vorschubgeschwindigkeit des Elektrodenpaares 8 wird auf 55 mm/min eingestellt. Durch die Temperatur des Lichtbogens 7 wird der Hohlzylinder 1 erweicht und geschmolzen. An der Innenwandung des Hohlzylinders 1 wird eine Maximaltemperatur von über 2100°C erreicht. Dabei bildet sich im Hohlzylinder 1 eine nach außen, in Richtung der Metallform 2 fortschreitende Schmelzfront 10, die die Grenzfläche zwischen dem noch offenporigen Bereich 11 des Hohlzylinders 1 und einem bereits teilweise geschmolzenen, opaken Bereich 12 des Hohlzylinders 1 bildet. Die Bewegungsrichtung 13 der Schmelzfront 10, die - durch die Vorschubgeschwindigkeit des Elektrodenpaares 8 überlagert ― im wesentlichen radial von der Innenwandung 9 der Innenbohrung 6 nach außen gerichtet ist, wird in Figur 1 schematisch anhand der Richtungspfeile 14 charakterisiert. Aufgrund der hohen Temperatur beim Schmelzen zersetzt sich das beigemischte Si₃N₄-Pulver. Dabei wird gasförmiger Stickstoff frei, der zur Porenbildung im opaken Bereich 12 führt und so die gewünschte Opazität des Bauteils erzeugt. Die Schmelzfront 10 des Hohlzylinders 1 endet ca. 6 cm vor der Innenwandung 5 der Metallform 2. Die verbleibende Körnungs-Schicht erleichtert die Entnahme des geschmolzenen Hohlzylinders 1 aus der Metallform 2 und dient gleichzeitig zur Wärmeisolierung.

Der Bereich der Innenwandung 9 der Innenbohrung 6 wird bei diesem Verfahren aufgrund der hohen Temperatur des Lichtbogens 7 stark verdichtet. Dadurch erhält der geschmolzene Formkörper 12 eine Innenzone 15, die aus transparentem Quarzglas hoher Dichte besteht.

Anhand **Figur 2** wird ein Ausführungsbeispiel für ein erfindungsgemäßes Bauteil, das eine dichte, transparente Innenzone 15 aufweist, näher erläutert. Sofern in Figur 2 die gleichen Bezugsziffern wie in Figur 1 verwendet werden, so sind damit gleiche oder äquivalente Bestandteile des erfindungsgemäßen Bauteils bezeichnet, wie sie anhand Figur 1 für die identischen Bezugsziffern erläutert sind.

Die Bezugsziffer 16 ist dabei einer rohrförmigen Muffel aus hochreinem opakem Quarzglas insgesamt zugeordnet. Die Muffel 16 hat einen Innendurchmesser von 140 mm, einen Außendurchmesser von 180 mm und eine Länge von ca. 240 mm. Die Muffel 16 weist eine Innenzone 15 aus transparentem Quarzglas mit einer Schichtdicke "S" von 200 µm auf. Die Innenzone 15 besteht aus Quarzglas mit einer mittleren Dichte von 2,18 g/cm³, und ist mit dem restlichen Formkörper 12 in Form einer Außenzone aus porenhaltigem, opakem Quarzglas integral verbunden.

Die Innenzone 15 zeichnet sich durch hohe mechanische Festigkeit und hohe chemische Beständigkeit aus. Darüber hinaus bewirkt die Innenzone 15 eine hohe thermische Beständigkeit der Muffel 16, was besonders bei einem Einsatz zur Durchführung wärmetechnischer Prozesse eine wichtige Rolle spielt.

## Patentansprüche

1. Verfahren für die Herstellung von opakem Quarzglas, durch Bereitstellen einer Mischung umfassend SiO₂-Partikel und ein bei der Schmelztemperatur dieser Partikel verdampfendes Zusatzmittel, Bilden eines Formlings aus der Mischung, und Verglasen des Formlings durch Erhitzen bei der Schmelztemperatur unter Bildung einer im Formling fortschreitenden Schmelzfront, **dadurch gekennzeichnet, daß** ein Formling (1) gebildet wird, der eine Innenbohrung aufweist, und daß das Erhitzen des Formlings (1) derart erfolgt, daß die Schmelzfront (10) von der Innenbohrung (6) nach außen fortschreitet, wobei Verunreinigungen und freiwerdende Gase in Richtung noch poröser Bereiche des Formlings getrieben werden.

2. Verfahren nach Anspruch 1, **dadurch gekennzeichnet, daß** der Formling (1) zonenweise entlang einer Längsachse (3) der Innenbohrung (6) erhitzt wird.

3. Verfahren nach Anspruch 2, **dadurch gekennzeichnet, daß** der Formling (1) um die Längsachse (3) der Innenbohrung (6) rotiert wird.

4. Verfahren nach einem der vorhergehenden Ansprüche, **dadurch gekennzeichnet, daß** das Erhitzen des Formlings (1) mittels eines Lichtbogens (7) erfolgt, und daß die Schmelztemperatur auf einen Wert oberhalb von 1900 °C eingestellt wird.

5. Verfahren nach einem der vorhergehenden Ansprüche, **dadurch gekennzeichnet, daß** als SiO₂-Partikel ein in einem Granulierverfahren hergestelltes Granulat aus synthetisch erzeugtem SiO₂ eingesetzt wird.

6. Verfahren nach Anspruch 5, **dadurch gekennzeichnet, daß** das Granulat vorverdichtet wird.

7. Verfahren nach einem der vorhergehenden Ansprüche, **dadurch gekennzeichnet, daß** ein Zusatzmittel eingesetzt wird, das eine, vorzugsweise mehrere der Komponenten Siliciumcarbid (SiC), Aluminiumnitrid (AIN), Siliciumnitrid (Si₃N₄), Zirkoniumoxid (ZrO₂) Zirkonsilikat (ZrSiO₄), Kohlenstoff (C) oder eine kohlenstoffhaltige Substanz enthält.

8. Verfahren nach einem der vorhergehenden Ansprüche, **dadurch gekennzeichnet, daß** ein Zusatzmittel eingesetzt wird, das nanoskaliges SiO₂-Pulver enthält.

9. Bauteil aus opakem, porenhaltigem Quarzglas, **dadurch gekennzeichnet daß** das Bauteil eine von einer Innenwandung (9) umschlossene Öffnung (6) aufweist, und es eine sich von der Innenwandung (9) über eine Strecke von 30 µm bis 500 µm radial nach außen erstrekkende Innenzone (15) mit einer Dichte von mindestens 2,15 g/cm³ aufweist.

10. Bauteil nach Anspruch 9, **dadurch gekennzeichnet, daß** die Innenzone (15) sich über eine Strecke im Bereich von 50 µm bis 200 µm erstreckt.

## Claims

1. A method for producing opaque quartz glass by providing a mixture comprising SiO₂ particles and an additive that is vaporizing at the melting temperature of these particles, forming a preform from the mixture and vitrifying the preform by heating at the melting temperature while forming an advancing melt front within the preform, **characterised in that** a preform (1) is formed having an inner bore and that the preform (1) is heated such that the melt front (10) advances from the inner bore (6) to the outer surface, while impurities and released gases are driven in the direction of still porous portions of the preform.

2. A method as claimed in claim 1, **characterised in that** the preform it) is heated zonewise along a longitudinal axis (3) of the inner bore (6).

3. A method as claimed in claim 2, **characterised in that** the preform (1 ) is rotated along the longitudinal axis (3) of the inner bore (6).

4. A method as claimed in one of the aforementioned claims, **characterised in that** the heating of the preform (1) is accomplished by an electric arc (7) and that the melting temperature is set at a value of more than 1900 °C.

5. A method as claimed in one of the aforementioned claims, **characterised in that** the SiO₂ particles used are a granulate produced in a granulating process from synthetically manufactured SiO₂.

6. A method as claimed in claim 5, **characterised in that** the granulate is precompacted.

7. A method as claimed in one of the aforementioned claims, **characterised in that** an additive is used which contains one, preferably several of the elements of silicon carbide (SiC), aluminum nitride (AIN), silicon nitride (Si₃N₄), zirconia (ZrO₂), zircon mineral (ZrSiO₄), carbon (C) or a substance containing carbon.

8. A method as claimed in one of the aforementioned claims, **characterised in that** an additive is used containing nano-scale SiO₂ powder.

9. A member made of opaque porous quartz glass, **characterised in that** the member has an opening (6) surrounded by an inner wall (9) and that it has an inner zone (15) having a density of at least 2,15 g/cm³, which radially extends over a distance of 30 µm to 500 µm from the inner wall (9) to the outer surface.

10. A member as claimed in claim 9, **characterised in that** the inner zone (15) extends over a distance in the range of 50 µm to 200 µm.

## Revendications

1. Procédé pour la fabrication de verre de silice opaque par préparation d'un mélange comprenant des particules de SiO₂ et un additif s'évaporant à la température de fusion de ces particules, par la formation d'une briquette à partir de ce mélange et par vitrification de la briquette par échauffement à la température de fusion en formant un front de fusion avançant dans la briquette, **caractérisé en ce qu'**une briquette (1) est formée qui présente un perçage interne et **en ce que** l'échauffement de la briquette (1) s'effectue dans le fait que le front de fusion (10) progresse depuis le perçage interne (6) en direction de l'extérieur, des impuretés et des gaz libérés étant propulsés vers les zones encore poreuses de la briquette.

2. Procédé selon la revendication 1, **caractérisé en ce que** la briquette (1) est échauffée par zone le long d'un axe longitudinal (3) du perçage interne (6).

3. Procédé selon la revendication 2, **caractérisé en ce que** la briquette (1) est tournée autour de l'axe longitudinal (3) du perçage interne (6).

4. Procédé selon l'une des revendications précédentes, **caractérisé en ce que** l'échauffement de la briquette (1) s'effectue au moyen d'un arc (7) et **en ce que** la température de fusion est paramétrée à une valeur supérieure à 1900°C.

5. Procédé selon l'une des revendications précédentes, **caractérisé en ce qu'**on utilise en tant que particule SiO₂ un granulat fabriqué dans un procédé de granulation à partir du SiO₂ produit synthétiquement.

6. Procédé selon la revendication 1, **caractérisé en ce que** le granulat est précompacté.

7. Procédé selon l'une des revendications précédentes, **caractérisé en ce qu'**un additif est utilisé qui contient un, de préférence, plusieurs des composants suivants : carbure de silicium (SiC), Nitrure d'aluminium, (AIN), nitrure de silicium (Si₃N₄), oxyde de zirconium (ZrO₂), silicate de zirconium (ZrSiO₄), carbone (C) ou une autre substance contenant du carbone

8. Procédé selon l'une des revendications précédentes, **caractérisé en ce qu'**un additif est utilisé qui contient de la poudre de SiO₂ de la taille du nanomètre.

9. Composant en verre de silice opaque et contenant des pores, **caractérisé en ce que** le composant présente une ouverture (6) entourée d'une paroi interne (9), et une zone interne (15) s'étendant de la paroi interne (9) sur une distance de 30 µm à 500 µm radialement vers l'extérieur avec une densité d'an moins 2,15 g/cm3.

10. Composant selon la revendication 9, **caractérisé en ce que** la zone interne (15) s'étend sur une distance comprise entre 50 µm et 200 µm.
